# EUROPEAN PATENT APPLICATION

(11) **EP 3 404 337 A1**
(43) Date of publication of application: **21.11.2018**
(21) Application number: 17738135.7
(22) Date of filing: 11.01.2017
(51) Int. Cl.: F24F 5/00, H05K 7/20

(54) **RADIANT AIR CONDITIONING SYSTEM FOR HEAT-PRODUCING DEVICE**

(30) Priority: 12.01.2016 CN 201610022403
(71) Applicant: Yan, Jiguang, Zhuhai, Guangdong 519015 (CN)
(72) Inventor: Yan, Jiguang, Zhuhai, Guangdong 519015 (CN)
(74) Representative: Bergmeier, Werner
(86) International application number: PCT/CN2017/070820
(87) International publication number: WO 2017/121321

(57) **Abstract**

The present invention provides a radiant air conditioning system for a heat-producing device (1), comprising a compressor (4), a condenser (5), an expansion valve (6), and at least one radiant panel evaporator (2) which are connected through a connecting pipe to form a recycling refrigerant loop, wherein each of the radiant panel evaporators comprises a refrigerant pipe (22) and a radiant panel (21) which exchanges heat with the refrigerant pipe (22). The radiant air conditioning system further comprises at least one heat transfer plate (3), configured to perform radiant heat transfer with the heat-producing device (1) and transmit an amount of absorbed heat to the radiant panel (21). The present invention improves heat transfer effect between the radiant panel (21) and the heat-producing device (1), and is particularly suitable for cooling a plurality of densely distributed heat-producing devices (1).

## Description

### FIELD OF THE INVENTION

The present invention relates to a radiant air conditioning system with radiant panel evaporators which is mainly used for cooling electronic heat-producing devices, especially used for cooling various heat-producing devices in a server, a base station etc., and particularly suitable for cooling a plurality of densely distributed heat-producing devices.

### BACKGROUND OF THE INVENTION

Chinese Invention Patent No.CN200810029359.6 discloses an air conditioning system comprising a radiation heat exchange ceiling plate. The conditioning system comprises a heat pump system and a water circulation system in which the water circulation system comprises a pump, an air heat exchange device, a water heat exchange device and a water circulation loop composed of a plurality of radiation heat exchange ceiling plate. In the conditioning system heat is exchanged with the outside air by means of the air heat exchange device, and heat is also exchanged with the heat pump system by means of the water heat exchange device. The radiation heat exchange ceiling plate comprises a metal ceiling plate, a heat exchange coil which is connected to the water circulation loop and a layer of heat insulating material on the top of the heat exchange coil in which the heat exchange coil is arranged on the top of the metal ceiling plate such that the heat exchange coil is adjacent to, but is not in contact with the metal ceiling plate.

Chinese Invention Patent No. CN201010158876.0 discloses an air-conditioning system for a base station comprising an independent radiant panel evaporator. The conditioning system comprises an outdoor unit, a radiant panel evaporator arranged in the machine room and a condensate water removal device in which the outdoor unit comprises a compressor, a condenser and an expansion valve. The radiant panel evaporator is connected with the compressor, the condenser and the expansion valve through a connecting pipe to form a recyclable closed loop. The radiant panel evaporator is composed of a plurality of panel-type evaporators in which the panel-type evaporator comprises a refrigerant pipe, a radiant panel, an inner radiant fin plate and heat insulation materials, in which the refrigerant pipe is connected with the inner radiation fin plate, the refrigerant pipe and the inner radiant fin plate are arranged between the radiant panel and the heat insulation materials, and the plurality of panel-type evaporators and the refrigerant pipe are communicated with each other through a connecting pipe.

In the above-mentioned technical solution, heat generated by devices in the base station is directly transferred to the radiant panel through radiation. The radiant panel transmits heat to the inner radiant fin plate, the inner radiation fin plate transmits heat to the liquid refrigerant in the refrigerant pipe, and the refrigerant absorbs heat, evaporates and is gasified back to the compressor, thereby completing the refrigeration cycle. But this technical solution is disadvantageous in that there is a limited area for radiant heat transferring between the devices of the base station and the radiant panel, and thus radiant heat transfer between them is not good enough. In such a case the devices of the base station would still distribute a large amount of heat to the ambient air. Because heat transfer by convection of air is not good with a rather low speed and thus more energy consumption is required to maintain the devices of the base station at a specified temperature. When a plurality of base station devices are arranged in the machine room, and particularly when the base station devices are densely arranged, they might block the radiant heat transfer path between the devices of the base station and the radiant panel for each other. In such a case the drawbacks of this technique becomes particularly obvious.

### DESCRIPTION OF THE INVENTION

To solve the above mentioned drawbacks, it is therefore one of the objectives of the present invention to provide a radiant air conditioning system with an improved radiant heat transfer between a radiant panel and a heat-producing device, which is particularly suitable for cooling a plurality of densely distributed heat-producing devices.

In order to achieve the above objectives, the present invention provides a radiant air conditioning system for heat-producing devices, comprising a compressor, a condenser, an expansion valve, and at least one radiant panel evaporator which are connected through a connecting pipe to form a recycling refrigerant loop, in which each of the radiant panel evaporators comprises a refrigerant pipe and a radiant panel which exchanges heat with the refrigerant pipe. The radiant air conditioning system further comprises at least one heat transfer plate, configured to perform radiant heat transfer with the heat-producing device, and transmit the absorbed heat to the radiant panel.

In the above technical solution, in the case that the radiant panel evaporator directly faces towards the heat-producing device, the radiant panel exchanges heat directly with the heat-producing device and at the same time further indirectly with the heat-producing device via the heat transfer plate. Even when it is difficult to directly exchange heat between the radiant panel evaporator and the heat-producing device, for example, when blockage of the cabinet, or the dense or stacked distribution of multiple heat-producing devices hamper the heat-producing devices to perform radiant heat transfer with the radiant panel, the heat-producing device can still perform heat transfer with the radiant panel evaporator by means of the heat transfer plate. It can be thus seen that the present invention increases the heat transfer paths between the radiant panel and the heat-producing device by providing a heat transfer plate, so that a better heat transfer between the radiant panel evaporator and the heat-producing device can be achieved. It is especially suitable for cooling multiple dense or stacked heat-producing devices.

In the present invention any kind of compressor can be used, but an inverter compressor is preferably employed to reduce power consumption. In addition, the condenser may adopt various cooling methods such as air cooling or water cooling, and a manual water cooling method is preferable because rapid cooling and condensing can be achieved and in the meantime a hot water recovery device for the condenser can be used to recover hot water for further utilization.

In the present invention, the heat transfer surface of the radiant panel and the heat transfer surface of the heat transfer plate may be formed as a flat surface, or may be formed as a undulation or other form of uneven surface such as a corrugated surface.

Alternatively, the metal heat transfer plate and the radiant panel can be interconnected with each other such that rapid heat transfer between the two can be achieved by both heat conduction and radiant heat transfer.

According to a preferred embodiment of the invention, the heat transfer plate is separated from the radiant panel and the heat transfer plate is arranged obliquely with respect to the radiant panel. The advantage of separating the heat transfer plate from the radiant panel is that the position of the heat transfer plate and the radiant panel evaporator can be flexibly arranged based on actual arrangement of the heat-producing device, providing convenience to the installation of the heat transfer plate and the radiant panel evaporator. In the meantime, the heat transfer plate is disposed to be inclined with respect to the radiant panel, so that the heat transfer plate will have better radiant heat transfer with both the heat-producing device and the radiant panel.

According to another preferred embodiment of the present invention, the heat transfer plate is disposed to perform radiant heat transfer with the main heat dispersing surface of the heat-producing device in order to better transfer heat generated by the heat-producing device to the radiant panel so that temperature of the heat-producing device will drop rapidly. The main heat dispersing surface of the heat-producing device refers to a surface, among all surfaces, that has a relatively large heat dispersing area or a surface where a relatively large amount of heat is dispersed.

In the present invention, the heat transfer plate can be separated from the heat-producing device such that the two exchange heat mainly by means of radiant heat transfer. Alternatively, the heat transfer plate may also be partially in contact with the heat-producing device, and in such a case heat exchanges between the two simultaneously by heat conduction and radiant heat transfer.

The radiant air conditioning system of the present invention can be used for cooling a plurality of heat-producing devices. In such a case there are a plurality of heat transfer plates, and the plurality of heat-producing devices and the plurality of heat transfer plates can be arranged in an array. And furthermore the plurality of heat-producing devices and the plurality of heat transfer plates can be alternately arranged in sequence in at least one array direction. The plurality of heat transfer plates may have same or different shapes, structures and/or sizes, and each heat transfer plate may be integrated as a whole or may be composed of a plurality of heat transfer sub-plates which are connected with or separated from one another. For example, the heat transfer plates disposed among the heat-producing devices may comprise two heat transfer sub-plates which form an angle with each other, or may be formed in a V-shaped structure, so as to achieve better heat transfer.

In the above technical solution, since the plurality of heat-producing devices and the plurality of heat transfer plates are alternately arranged in the at least one array direction, it is thus ensured that the radiant panels can simultaneously exchange heat with all the heat-producing devices through the heat transfer plates to quickly and evenly cool down all heat-producing devices. In addition, this arrangement will also leads to reduced space occupied by the air conditioning system and simplified structure.

According to a specific embodiment of the present invention, in at least one array direction, any two adjacent heat-producing devices are separated by a heat transfer plate disposed there-between, so that radiation cannot be carried out between the two adjacent heat-producing devices. This has the advantage that not only is thermal interference between adjacent heat-producing devices avoided or reduced, but also the radiant heat transfer area between the heat transfer plates and the heat-producing devices is increased, and the radiant heat transfer effect is thus further improved.

In the present invention, the core plate used to clothe the refrigerant pipe may be contacted with the radiant panel, but this may cause the local temperature of some areas of the radiant panel to be lower than the dew forming temperature, which will lead to dew formation on the radiant panel. Therefore, it is preferable that the core plate used for the refrigerant pipe is spaced apart from the radiant panel.

As an embodiment of the present invention, the radiant panel evaporator further comprises a thermal insulated mesh bracket for separating the core plate of the refrigerant pipe from the radiant panel to prevent or reduce dew formation. The advantage of using a thermal insulted mesh bracket is that even when the refrigerant pipe and/or the radiant panel are deformed during transportation or use, the refrigerant pipe will not contact the radiant panel. For this core plate structure the areas contacted with the refrigerant pipe have the lowest temperature. That means there is not even temperature distribution on the surface of the core plate. When the core plate of the refrigerant pipe is separated from the radiant panel they exchange heat via radiation, and the cold thermal lines of the cold refrigerant pipe will perform an angular coefficient radiation when it exchange heat with the radiant panel. Thus the temperature field on the radiant panel will be more even without cold thermal lines forming on it.

In the present invention, the expansion valve may be a thermal expansion valve or an electronic expansion valve. Preferably, an electronic expansion valve is used, because it not only reduces energy consumption, but also enables precise and wide range control on the opening degree of the expansion valve and on the flow rate of the refrigerant via a control device. Correspondingly, a temperature sensor is disposed on the radiant panel, and the control device controls or adjusts the opening degree of the electronic expansion valve based on the temperature detected by the temperature sensor and a set temperature.

According to another embodiment of the invention, the heat transfer surface of the radiant panel and the heat transfer surface of the heat transfer plate are both coated with a black coating to increase their radiant heat transfer efficiency.

According to another embodiment of the present invention, the radiant panel evaporator further comprises an inner radiant fin plate connected to the refrigerant pipe but separated from the radiant panel, and the inner radiant fin plate is capable of radiant heat transfer with the radiant panel and thus the absorbed heat can be quickly conducted to the refrigerant pipe to enhance heat transfer efficiency between the radiant panel and the refrigerant pipe.

Preferably, the radiant panel evaporator further comprises a layer of thermal insulating material. The layer of thermal insulating material and the radiant panel together define a sealed accommodating space into which the refrigerant pipe and the inner radiant fin plate are placed. This is advantageous in that the refrigerant pipe directly and indirectly exchanges heat only with the radiant panel, thereby improving heat exchange efficiency between the two, and facilitating the control to the air conditioning system.

The present invention will be further described in detail below in conjunction with the drawings and preferable embodiment.

### BRIEF DESCRIPTION OF THE DRAWINGS

- **FIG. 1**: is a schematic view of an embodiment of a radiant air conditioning system according to the present invention;
- **FIG. 2**: is a schematic structural view of a radiant panel evaporator in an embodiment of a radiant air conditioning system according to the present invention;
- **FIG. 3**: is a schematic view showing the pipeline connection of an embodiment of a radiant air conditioning system according to the present invention;
- **FIG. 4**: is a schematic view showing the mounting structure of an embodiment of a radiant air conditioning system according to the present invention.

Numeral references in these figures are as follows:
1 heat-producing device such as a server,
2 radiant panel evaporator,
3 metal heat transfer plate,
4 compressor,
5 condenser,
6 expansion valve,
7 refrigerant supply pipe,
8 refrigerant return pipe,
9 temperature sensor,
10 air supply outlet,
11 air return inlet, and
12 water drain

### PREFERABLE EMBODIMENTS OF THE INVENTION

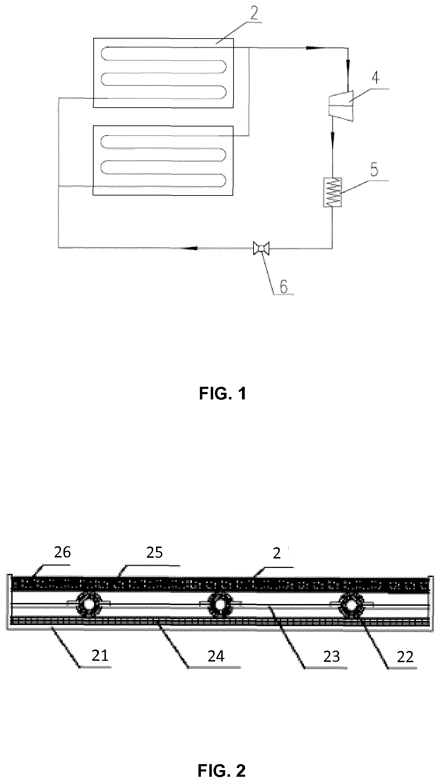

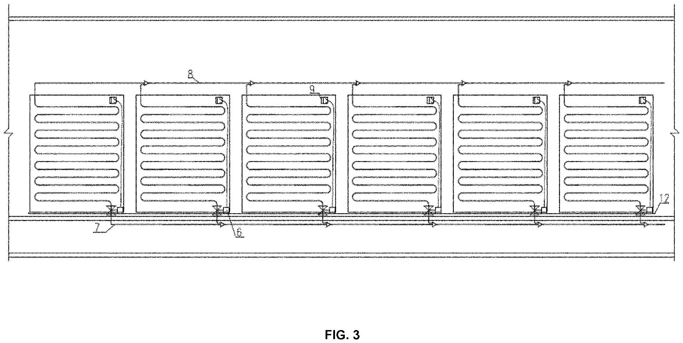

FIG. 1 is a schematic diagram of an embodiment of a radiant air conditioning system according to the present invention. FIG. 2 is a schematic structural view of a radiant panel evaporator in an embodiment of a radiant air conditioning system according to the present invention. FIG. 3 is a schematic diagram of a pipeline connection of an embodiment of a radiant air conditioning system according to the present invention. As shown in FIGS. 1 to 3, in this embodiment, the radiant air conditioning system comprises a plurality of radiant panel evaporators 2, a compressor 4, a condenser 5, and an expansion valve 6 which are arranged in parallel. The radiant panel evaporator 2, the compressor 4, the condenser 5 and the expansion valve 6 are sequentially connected via a connecting pipe to form a recyclable refrigerant loop, in which the compressor 4 is an inverter compressor; the condenser 5 is a water-cooled or air-cooled condenser; and the expansion valve 6 is an electronic expansion valve.

As shown in FIG. 2, the radiant panel evaporator 2 comprises an aluminum radiant panel 21 which defines an accommodating space, a meandering copper refrigerant pipe 22 which is placed into the accommodating space and clad by an aluminum core plate 23, an aluminum core plate 23 which is thermally conductive connected with the copper refrigerant pipe 22 and is substantially parallel with the aluminum radiant panel 21, and a mesh bracket 24 made from thermal insulating material which is disposed between the copper refrigerant pipe 22 and the aluminum radiating plate 21 in such a way that the copper refrigerant pipe 22 and the aluminum inner radiant fin plate (core plate) 23 are spaced apart from the aluminum radiant panel 21. The inner surface of the aluminum radiant panel 21 and the surface of the inner radiating fin 23 facing towards the aluminum radiant panel 21 are coated with a black matt paint to make the blackness degree of radiant heat transfer to about one. The radiant panel evaporator 2 further comprises a layer of heat insulating material 25 for covering the copper refrigerant pipe 22 and the inner radiant fin plate 23 and for sealing this accommodating space, and the two opposite surfaces of the layer of heat insulating material 25 are respectively covered with aluminum foils 26 and 27.

The heat absorbed by the radiant panel 21 is mainly transferred to the inner radiant fin plate 23 and the copper refrigerant pipe 22 by means of radiant heat transfer, and the heat absorbed by the inner radiant fin plate 23 is further transferred to the copper refrigerant pipe 22. The liquid refrigerant which flows through the copper refrigerant pipe 22 absorbs the heat of the copper refrigerant pipe 22 to form refrigerant vapor, and the refrigerant vapor enters the compressor 4. Then the compressed high-temperature refrigerant vapor enters the condenser 5. The refrigerant vapor which has a high pressure and a high temperature is condensed to become a liquid refrigerant, and the liquid refrigerant passes through the expansion valve 6 to enters the copper refrigerant pipe 22 again to absorb heat. This cycle repeats continuously for heat transfer.

As shown in FIG. 3, the refrigerant supply pipe 7 is for conveying the liquid refrigerant to the plurality of radiant panel evaporators 2 which are arranged in parallel, and the refrigerant vapor generated by the heat absorbed by the radiant panel evaporators 2 is output through the refrigerant return pipe 8. Each of the radiant panel evaporators 2 is correspondingly disposed with an expansion valve 6, and a temperature sensor 9 for detecting the temperature of a radiant panel 21 is provided on the upper portion of the radiant panel 21 of each radiant panel evaporator 2. Based on the temperature detected by the temperature sensor 9 and a set temperature, the control device automatically controls or adjusts the degree of valve opening of each expansion valve 6, thereby regulating the flow rate of the refrigerant delivered to each radiant panel evaporator 2. The adjustment of the refrigerant flow rate in each of the radiant panel evaporators 2 is performed independently so that the refrigerant in the lower portion of each radiant panel evaporator 2 is in a liquid state, the refrigerant in the middle portion is in a two-phase boiling state, the refrigerant in the upper-middle portion is in the state of saturated vapor, and the refrigerant in the upper portion is overheated in order to avoid possible wet compression.

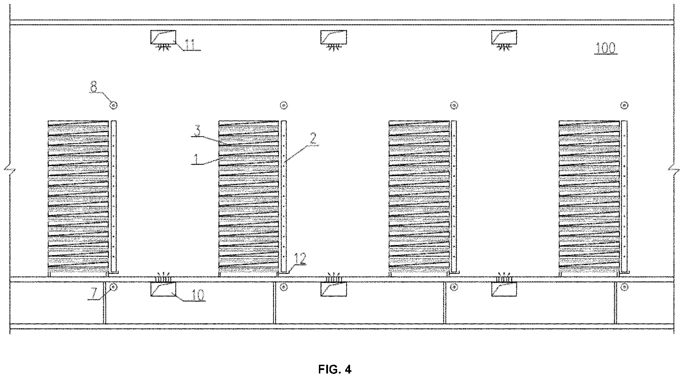

FIG. 4 is a schematic view showing the mounting structure of an embodiment of a radiant air conditioning system of the present invention. As shown in FIG. 4, in this embodiment, the radiant panel evaporator 2 is vertically disposed, and each radiant panel evaporator 2 is correspondingly arranged with a plurality of heat transfer plates 3. The heat transfer plate 3 is adjacent to but not contacted with the radiant panel 21, and it is inclined with respect to the radiant panel 21. Two opposite surfaces of the heat transfer plate 3 are also coated with a black matt coating such that the blackness degree of the radiant heat transfer is close to one.

A plurality of heat-producing devices 1 (such as servers) are placed in the machine room 100, and each server 1 is formed as a flat box-shaped body which is placed in such a manner that the largest surface is horizontal. A plurality of servers 1 and a plurality of heat transfer plates 3 are disposed in an array, and each sever 1 and each heat transfer plate 3 are alternately arranged in the vertical array direction such that radiant heat transfer is performed between the largest surface of each server 1 and its corresponding heat transfer plate(s) 3. The heat transfer plates 3 are configured to completely overlap the adjacent servers 1 in the vertical array direction to separate any two adjacent servers 1 from each other in the vertical array direction.

The heat generated inside each server 1 is transferred to its outer casing by radiation or the like. There is a temperature difference between the server casing and the heat transfer plate 3 so that heat in the server casing is mainly transferred to the heat transfer plate 3 by means of radiant heat transfer. There is also a temperature difference between the heat transfer plate 3 and the radiant panel 21 so that the heat in the heat transfer plate 3 is mainly transferred to the radiant panel 21 by means of radiant heat transfer. By controlling the flow rate of the refrigerant in the radiant panel evaporator 2, the temperatures of the surface of the radiant panel 21, of the surface of the heat transfer plate 3, of the surface of the server casing, and of the interior of the server can be sequentially controlled. Generally, as the working state of the server 1 changes, the amount of heat generated varies greatly. In order to maintain a stable working state of the server 1, it is necessary to automatically adjust the refrigerant flow entering the radiant panel evaporator 2 according to the temperature of the radiant panel 21 detected by the temperature sensor 9.

Referring again to FIG. 4, a plurality of air supply outlets 10 are disposed at a lower portion of the machine room 100, and a plurality of air return inlets 11 are disposed at an upper portion thereof. The air supply outlets 10 and the air return inlets 11 are respectively provided with electric control valves (not shown) which are connected to a humidity sensor and the circuit of an automatic control device. The radiant air conditioning system further comprises a dehumidifier (not shown) in which dry air is sent into the machine room 100 from the air supply outlets 10 and the air in the machine room 100 is returned to the dehumidifier via the air return inlets 11, so as to control the relative humidity in the machine room 100. In order to cope with dew formation of the radiant panel 21 in case that the possible humidity is out of control, a draining tank 12 is provided at the lower portion of the radiant panel evaporator 2.

While the present invention is depicted by the above embodiments of the present invention, it should be understood that variations, modifications and applications can be made by those skilled in the art without departing from the inventive concept and scope of this invention.

## Claims

1. A radiant air conditioning system for heat-producing device, comprising a compressor, a condenser, an expansion valve, and at least one radiant panel evaporator which are connected through a connecting pipe to form a recycling refrigerant loop,
wherein each of the radiant panel evaporators comprises a refrigerant pipe and a radiant panel which exchanges heat with the refrigerant pipe, and
wherein the radiant air conditioning system further comprises at least one heat transfer plate in which the heat transfer plate performs radiant heat transfer with the heat-producing device and transmits the absorbed heat to the radiant panel.

2. The radiant air conditioning system according to claim 1, wherein the heat transfer plate is separated from the radiant panel, and the heat transfer plate is arranged obliquely with respect to the radiant panel.

3. The radiant air conditioning system according to claim 1, wherein the heat transfer plate is arranged to conduct radiant heat transfer with main heat dispersing surfaces of the heat-producing device.

4. The radiant air conditioning system according to claim 1, wherein the radiant air conditioning system is used for cooling a plurality of heat-producing devices, and wherein a plurality of heat transfer plates are arranged, the plurality of heat-producing devices and the plurality of heat transfer plates are arranged in an array, and the plurality of heat-producing devices and the plurality of heat transfer plates are alternately arranged in sequence in at least one array direction.

5. The radiant air conditioning system according to claim 4, wherein any two adjacent heat-producing devices are separated by one heat transfer plate disposed there-between in at least one array direction.

6. The radiant air conditioning system according to claim 1, wherein the radiant panel evaporator further comprises a heat insulation mesh bracket for separating the refrigerant pipe from the radiant panel.

7. The radiant air conditioning system according to claim 1, wherein the expansion valve is an electronic expansion valve and a temperature sensor is disposed on the radiant panel, in which a control device controls or adjusts the opening degree of the electronic expansion valve based on the temperature detected by the temperature sensor and a set temperature.

8. The radiant air conditioning system according to claim 1, wherein the heat transfer surface of the radiant panel and the heat transfer surface of the heat transfer plate are coated with a black coating.

9. The radiant air conditioning system according to claim 1, wherein the radiant panel evaporator further comprises an inner radiant fin plate connected to the refrigerant pipe but separated from the radiant panel.

10. The radiant air conditioning system according to claim 9, wherein the radiant panel evaporator further comprises a layer of insulating material in which the layer of insulating material and the radiant panel together define a sealed accommodating space in which the refrigerant pipe and the inner radiant fin plate are disposed.
